**Europäisches Patentamt**

**European Patent Office**

**Office européen des brevets**

(19)

(11) Veröffentlichungsnummer : **0 365 780 B1**

(12)

# EUROPÄISCHE PATENTSCHRIFT

(45) Veröffentlichungstag der Patentschrift :
**26.04.95 Patentblatt 95/17**

(51) Int. Cl.⁶ : **H04Q 1/14**

(21) Anmeldenummer : **89115536.8**

(22) Anmeldetag : **23.08.89**

(54) Anschlussvorrichtung zum Schalten oder Trennen von Leitungswegen in Fernsprechvermittlungsanlagen.

(30) Priorität : **25.10.88 DE 3836668**

(43) Veröffentlichungstag der Anmeldung :
**02.05.90 Patentblatt 90/18**

(45) Bekanntmachung des Hinweises auf die
Patenterteilung :
**26.04.95 Patentblatt 95/17**

(84) Benannte Vertragsstaaten :
**AT BE CH DE ES FR GB GR IT LI LU NL SE**

(56) Entgegenhaltungen :
**EP-A- 0 200 883**
**EP-A- 0 209 822**
**EP-A- 0 243 296**
**FR-A- 2 469 020**

(73) Patentinhaber : **KRONE Aktiengesellschaft**
**Beeskowdamm 3-11**
**D-14167 Berlin (DE)**

(72) Erfinder : **Delakowitz, Bernd**
**Weinbergshöhe**
**Rebenweg 2**
**D-1000 Berlin 20 (DE)**
Erfinder : **Hegner, Gunter**
**Moränenweg 22**
**D-1000 Berlin 27 (DE)**

## Beschreibung

Die Erfindung bezieht sich auf eine Anschlußleiste zum Schalten oder Trennen von Leitungswegen in Fernsprechvermittlungsanlagen gemäß dem Oberbegriff des Anspruches 1.

Eine Anschlußvorrichtung dieser Art für einen Hauptverteiler ist aus der DE-PS 25 18 832 vorbekannt. Die Anschlußleiste der Anschlußvorrichtung besteht aus einem Kunststoffkörper, in dem mehrere Kontaktpaare eingelegt sind. Diese Kontaktpaare sind an den Unterseiten derart verlängert und zueinander gerichtet, daß zwischen den Kontakten Trennstellen gebildet sind. An je einem Kontaktpaar wird eine ankommende und eine abgehende Leitungsader eines Leitungsweges angeschlossen, der über die Trennstelle auftrennbar ist. Zum Anschluß eines aus a-Ader und b-Ader bestehenden Leitungsweges sind insgesamt vier Anschlußkontakte bzw. zwei Kontaktpaare notwendig. Auf der einen Seite der Anschlußleiste werden vorzugsweise Rangierleitungen und auf der anderen Seite der Anschlußleiste Teilnehmerleitungen oder Vermittlungsleitungen angeschlossen, entsprechend der Verwendung der Anschlußleiste auf der Vermittlungs- oder Teilnehmerseite eines Hauptverteilers.

Eine derartige Anschlußvorrichtung hat jedoch den Nachteil, daß spezielle Schaltfunktionen nur sehr aufwendig durchführbar sind. So ist ein Umschalten von einem ersten Leitungsweg auf einen zweiten Leitungsweg nur mittels einer weiteren Anschlußvorrichtung möglich, bei der die Leitungen für den zweiten Leitungsweg neu angeschlossen werden müssen. Dieses ist oft aus Platzgründen nicht möglich, da die vorhandenen Anschlußvorrichtungen bereits den größten Teil des Verteilers belegen. Es muß zunächst für den ersten Leitungsweg die Anschlußvorrichtung mit einer vergleichsweisen geringen Anschlußkapazität gegen eine Anschlußvorrichtung mit einer höheren Anschlußkapazität ersetzt, neu rangiert und vermittlungsseitig neu verkabelt werden. Hierdurch entsteht der benötigte Platz für die Installation von Anschlußvorrichtungen für den zweiten Leitungsweg mit Rangier- und Kabelanschlüssen für z.B. eine neue digitale Vermittlungsanlage. Diese muß nochmals neu rangiert und durchgeprüft werden, wobei vor der Beschaltung mit den Rangierleitungen die Trennstelle mittels Trennstecker geöffnet werden muß. Beim Umschalten muß an der ersten Anschlußvorrichtung für den ersten Leitungsweg die Trennstelle mittels Trennstecker geöffnet und an der zweiten Anschlußvorrichtung für den zweiten Leitungsweg die Trennstelle durch Ziehen des Trennsteckers geöffnet werden. Die Umschaltung kann wegen der örtlichen Entfernung der beiden Anschlußvorrichtungen nur durch zwei Personen auf Zuruf erfolgen, wodurch ein erheblicher Unsicherheitsfaktor bei der Bedienung entsteht, der zu Fehlschaltungen führen kann. Nach erfolgter Umschaltung werden die Anschlußvorrichtungen für den ersten Leitungsweg einschließlich Rangierung und Vermittlungsleitung wieder demontiert, wodurch ein großer Teil des Verteilers wieder frei wird und zunächst ungenutzt bleibt. Bei erneuten Umschaltungen werden an diesem freien Platz wieder neue Anschlußvorrichtungen installiert, rangiert und verkabelt; die vorher genutzten Geräte einschließlich ihrer Rangierungen und Verkabelungen werden entfernt. Dieser Umschaltvorgang ist sehr aufwendig, insbesondere durch die Verkabelungs- und Prüfungsarbeiten.

Weiterhin nachteilig ist, daß bei nur einer vorhandenen Trennstelle diese nur für einen Schaltzweck zugänglich ist, d.h. daß bei einem z.B. eingesteckten Dämpfungs- oder Schutzstecker kein Prüfsteker mehr eingesteckt werden kann. Außerdem decken die in die Trennstelle gesteckten Elemente die Anschlußkontakte soweit ab, daß ein Beschalten der Kontakte mit Leitungen nicht möglich ist.

Aus der Druckschrift EP-A-0 243 296 ist eine Verteilereinrichtung mit zwei Kontaktpaaren und zwei Trennstellen bekannt. Das eine Kontaktpaar dient hierbei zum Anschluß der Vermittlungsleitungen, während das andere Kontaktpaar zum Anschluß der Teilnehmerleitung dient. Zwischen den Kontakten ist jeweils eine Trennstelle vorgesehen. Nachteilig hierbei ist, daß nur dieser starre Aufbau zwischen Teilnehmerleitung und Vermittlungsleitung verwendet werden kann. Darüber hinaus besteht der Nachteil, daß Vermittlungsleitung und Teilnehmerleitung auf verschiedenen Seiten (Vorder- und Rückseite bzw. Anschalteseite und Manipulierseite) angeordnet sind, so daß die Bedienperson um das Gestell herumlaufen muß. Die Anordnung ist auch als Wandgestell nicht einsetzbar.

Aufgabe der Erfindung ist es daher, eine Anschlußleiste der gattungsgemäßen Art zu schaffen, die verschiedene Schaltfunktionen, insbesondere das Umschalten von einem Leitungsweg auf einen anderen Leitungsweg auf einfachste und wirtschaftlichste Art ermöglicht.

Die Lösung dieser Aufgabe ergibt sich aus den kennzeichnenden Merkmalen des Patentanspruches 1.

Weitere vorteilhafte Ausgestaltungen der Erfindung ergeben sich aus den Unteransprüchen. Gemäß einer bevorzugten Ausführung nach Anspruch 7 wird zum Austausch der alten bisher verwendeten Anschlußvorrichtung die erfindungsgemäße Anschlußvorrichtung zuerst an einem freien Platz montiert. Für den ersten Leitungsweg werden die Vermittlungs- und Rangierleitungen an die Anschlußkontakte angeschlossen. Bei der alten, nicht mehr benötigten Anschlußvorrichtung werden die Leitungen entfernt. Die alte Anschlußvorrichtung wird danach demontiert. An ihren Platz wird wieder eine neue Anschlußvorrichtung gesetzt, und für weitere erste Leitungswege werden neue Vermittlungsleitungen und Rangierleitungen angeschlossen. So wird nach und nach jede Anschlußvorrichtung beschaltet, bis alle alten Anschlußvorrichtungen gegen neue Anschlußvorrichtungen ausgetauscht sind. Je nach Art der vorhandenen Anschlußvorrichtungen ist die Anschlußkapazität der neuen Anschlußvorrichtungen mindestens gleich bis doppelt so hoch.

Danach werden die Vermittlungsleitungen für den zweiten Leitungsweg z.B. zu einer digitalen Vermittlunsanlage gelegt. Vor dem Anschließen an das zusätzliche Kontaktpaar werden die zusätzlichen zweiten Trennstellen mittels Trennstecker geöffnet.

Eine erneute Rangierung und eine damit verbundene Prüfung des Rangierleitungsweges ist hier nicht mehr notwendig. Zum Zeitpunkt der Umschaltung wird an den ersten Trennstellen des ersten Leitungsweges ein Trennstecker gesteckt und der Trennstecker der zusätzlichen zweiten Trennstellen für den zweiten Leitungsweg gezogen. Dieser Trennstecker wird wiederum in die Trennstellen eines weiteren ersten Leitungsweges einer anderen Anschlußleiste gesteckt. Dies kann wegen der örtlichen Nähe der Trennstellen für den ersten und zweiten Leitungsweg sehr schnell, einfach und sicher von nur einer Person durchgeführt werden. Nach erfolgter Umschaltung werden lediglich die vermittlungsseitigen Leitungen des ersten Leitungsweges entfernt. Das freigewordene Kontaktpaar mit zugehörigen Trennstellen kann in gleicher Weise wieder für spätere Umschaltungen oder durch Schließen der ersten Trennstellen für parallele Anschaltungen (Doppelkontaktierung) oder weiterhin durch Öffnen der zweiten Trennstellen für Ersatzschaltungen verwendet werden. Damit entfällt jeglicher weiterer Gerätewechsel bei weiteren Umschaltmaßnahmen sowie das damit verbundene neue Rangieren und Prüfen der Rangierleitungen.

Die Anordnung gemäß Anspruch 1 bewirkt, daß die Trennstellen räumlich von den Anschlußkontakten getrennt sind. Dadurch ist es problemlos möglich, auch bei in den Trennstellen eingesteckten Steckern die Anschlußkontakte zu be- und entschalten, ohne daß die Stecker behindern oder entfernt werden müßten.

Ein weiterer Vorteil ergibt sich aus dem Anspruch 2. Durch die Leitungsführung innerhalb der Anschlußleiste wird kein zusätzliches Bauelement als Drahtführungselement benötigt. Die Dicke der Anschlußleiste wird trotz Drahtführung nicht erweitert.

Gemäß Anspruch 4 können für dreiadrig (a-,b-,c-Ader) geführte Vermittlungsleitungen an der oberen Längsseite der Anschlußleiste Adapter gleicher Dicke aufgerastet werden, die Anschlußkontakte für die c-Adern aufweisen. Die Anschlußkontakte sind mit Trennkontakten verbunden, deren Trennstelle in einer Ebene mit der a-,b-Trennstelle der Anschlußleiste liegt und somit eine vollständige a-, b-, c-Trennstelle bildet.

Die Anordnung gemäß Anspruch 8 ermöglicht durch das Vorhandensein von zwei Trennstellen, bei entsprechender Leitungsführung auf der Leiterplatte, die Trennstellen in Reihe zu schalten. Dadurch ist es möglich, zwei unterschiedliche Schaltfunktionen gleichzeitig auszuführen, z.B. in eine Trennstelle einen Dämpfungs- oder Schutzstecker zu stecken und die andere Trennstelle für Trennstecker oder Prüfschnüre zu verwenden.

Die Anordnung gemäß Anspruch 9 ermöglicht, daß zwischen drei Kontaktpaaren jeweils eine Trennstelle in Reihe geschaltet ist, wobei ein Kontaktpaar zum Anschluß der ankommenden und ein Kontaktpaar zum Anschluß für die abgehende Leitung vorgesehen ist. Das zwischen diesen beiden Kontaktpaaren angeordnete dritte Kontaktpaar kann mit einer weiteren Leitung belegt werden, die wahlweise über beide Trennstellen parallel mit der ankommenden und abgehenden Leitung oder durch Auftrennen der einen oder anderen Trennstelle nur mit einer der beiden Leitungen verbunden ist.

Gemäß Anspruch 10 wird die c-Ader durch einen von der Aufnahmewanne und der Anschlußleiste gebildeten Leitungskanal zum Adapter geführt. Nach erfolgter Umschaltung und dem Entfernen der a-, b- und c-Leitungen des Vermittlungskabels für den ersten Leitungsweg können die Adapter wieder entfernt und somit die Abmessungen der Anschlußvorrichtung verkleinert werden.

An der unteren Seite der Anschlußleiste können gemäß Anspruch 11 Adapter aufgerastet werden, wobei jeweils zwei (a,b) oder drei (a,b,c) Adapter Anschlußkontakte mit Trenn- oder Schaltkontaktstellen aufweisen, um hieran eventuell benötigte Sonderleitungen (Verbindungsleitungen, Ansagedienst, Erdstützpunkte) anschließen und abgreifen zu können. Diese können nach erfolgter Umschaltung bei Nichtbedarf wieder entfernt werden, wodurch die Abmessungen der Anschlußvorrichtung weiter verkleinert werden.

Die Erfindung ist nachfolgend anhand eines in den Zeichnungen dargestellten Ausführungsbeispieles einer Anschlußvorrichtung näher erläutert. Es zeigt:

| | |
|---|---|
| Fig. 1 | eine perspektivische Darstellung mehrerer in eine Aufnahmewanne eingesetzter Anschlußleisten, |
| Fig. 2 | eine perspektivische Darstellung einer Anschlußleiste mit zwei Adaptern, |
| Fig. 3 | eine perspektivische Darstellung der Anschlußkontakte und der Trennstellen, |
| Figuren 4, 5 und 6 | Querschnitte durch die Anschlußleiste zur Darstellung des Umschaltvorganges in einem ersten Ausführungsbeispiel, |
| Fig. 4a | ein der Fig. 4 zugeordnetes Schaltbild, |
| Fig. 7 | einen Querschnitt durch die Anschlußleiste in einem zweiten Ausführungsbeispiel und |

Fig. 7a    ein der Fig. 7 zugeordnetes Schaltbild,

Fig. 8    einen Querschnitt durch die Anschlußleiste in einem dritten Ausführungsbeispiel.

Fig. 8a    ein der Fig. 8 zugeordnetes Schaltbild.

Die Anschlußleiste 20 der Anschlußvorrichtung ist aus einem rechteckigen, scheibenförmigen Kunststoffgehäuse 29 gebildet und dient zur Aufnahme von Anschlußkontakten 1 bis 6 und von Trennkontakten 21 bis 28, die im Inneren des Kunststoffgehäuses 29 eingesetzt sind. Die sechs Anschlußkontakte 1 bis 6 bzw. die drei Kontaktpaare bestehen aus metallischen Schneid-Klemm-Kontakten zum Anschluß von isolierten a- und b-Kabeladern der Vermittlungs-, Rangier- und Teilnehmerleitungen VL1, VL2, RL1, TL1.

Die Trennkontakte 21 bis 28 bestehen aus metallischen, streifenförmigen Elementen, wobei jeweils zwei Trennkontakte 21 bis 28 an ihren oberen Enden abgebogen und zueinandergerichtet sind und am Berührungspunkt eine Trennstelle 7,8;10,11 bilden. In der Anschlußleiste 20 sind im Ausführungsbeispiel sechs Anschlußkontakte 1 bis 6 bzw. drei Kontaktpaare und acht Trennkontakte bzw. vier Trennstellen 7,8;10,11 vorgesehen. Die Anschlußkontakte 1 bis 6 sind zwischen den vier Trennstellen 7,8;10,11 angeordnet, wobei die Trennkontakte 21 bis 28 und die Anschlußkontakte 1 bis 6 hintereinander in einer Ebene ausgerichtet sind. An den unteren Enden der Anschlußkontakte 1 bis 6 und der Trennkontakte 21 bis 28 sind streifenförmige Verlängerungen 30 vorgesehen, die an ihren Enden um 90° abgebogene Haken 31 aufweisen. Diese Haken 31 ragen in Bohrungen 19 einer im hinteren Bereich der Anschlußleiste 20 angeordneten Leiterplatte 17 hinein. Die Leiterplatte 17 weist Leiterbahnen 18 auf, die die Bohrungen 19 und somit die Trennkontakte 21 bis 28 mit den Anschlußkontakten 1 bis 6 verbindet. Entsprechend der gewünschten Schaltfunktion sind verschiedene Verbindungsmöglichkeiten zwischen den Trennkontakten 21 bis 28 und den Anschlußkontakten 1 bis 6 möglich, wie später noch näher erläutert werden wird.

Das scheibenförmige Gehäuse 29 der Anschlußleiste 20 besitzt eine obere und eine untere Längsseite 32,33 und eine vordere und eine hintere Schmalseite 34,35. An der vorderen Schmalseite 35 sind für jeden Anschlußkontakt 1 bis 6 zwei Halterippen 36 vorgesehen, die zur Fixierung der anzuschließenden Kabelader dienen. Zwischen einem Kontaktpaar 1,2;3,4;5,6 ist jeweils zwischen den Halterippen 36 eine Isolierrippe 37 ausgebildet, hinter der das abgeschnittene Drahtende der angeschlossenen Kabelader versenkt wird, um den elektrisch notwendigen Isolationsabstand zweier zueinander gerichteter, abgeschnittener Leitungsenden bei geringstem Platzbedarf zu gewährleisten.

Des weiteren sind an der vorderen Schmalseite 35 im Gehäuse 29 Aufnahmeöffnungen 38, z.B. für Trennstecker 15 vorgesehen, die als Zugang zu den Trennstellen 7,8;10,11 dienen. Zur Führung und Fixierung der Vermittlungs-, Rangier- und Teilnehmerleitungen VL1, VL2, RL1, TL1 ist zwischen den Anschlußkontakten 1,2;3,4;5,6 eines Kontaktpaares in der Anschlußleiste 20 jeweils ein Leitungsführungskanal 9 vorgesehen. Insgesamt sind für die sechs Anschlußkontakte 1 bis 6 drei Führungskanäle 9 in der Anschlußleiste 20 angeordnet, die jeweils eine Eintrittsöffnung 43 und eine Austrittsöffnung 44 besitzen. Der mittlere Leitungsführungskanal 9 besitzt zwei Eintrittsöffnungen 43. Die Eintrittsöffnungen 43 der Leitungsführungskanäle 9 sind an den Längsseiten 32,33 und die Austrittsöffnungen 44 zwischen den Kontaktpaaren an der vorderen Schmalseite 35 angeordnet. Die Leitungsführungskanäle 9 werden innerhalb der Anschlußleiste 20 um ca. 90° umgelenkt, so daß die Führungskanäle 9 bogenförmig gestaltet sind. Im Ausführungsbeispiel verläuft der Führungskanal 9 für das obere Kontaktpaar 1,2 von der oberen Längsseite 32, für das untere Kontaktpaar 5,6 von der unteren Längsseite 33 und für das mittlere Kontaktpaar 3,4 von der unteren und oberen Längsseite 32,33 zur vorderen Schmalseite 35. Die Leitungen VL1, VL2, TL1, RL1 werden somit von der oberen oder unteren Längsseite 32,33 in die Führungskanäle 9 der Anschlußleiste 20 eingeschoben und bis an die Anschlußkontakte 1 bis 6 herangeführt, an denen sie mittels eines nicht dargestellten Werkzeuges angeschlossen werden.

An beiden Längsseiten 32,33 der Anschlußleiste 20 sind T-förmige Führungselemente 40 vorgesehen, an deren Enden ein zur hinteren Schmalseite 34 gerichteter Rasthaken 41 angeordnet ist. Der Rasthaken 41 weist an seiner Oberseite ein weiteres Rastelement 42 auf. Über das T-förmige Führungselement 40 und das Rastelement 42 können somit an den Längsseiten 32,33 zusätzlich Adapter 13,14 zum Anschluß von c-Adern der Vermittlungsleitung VL1 oder Sonderleitungen SL1 aufgeschoben und aufgerastet werden. Die Kunststoffkörper der Adapter 13 besitzen hierzu an den Unterseiten T-förmige Nuten 45 und eine am hinteren Ende des Adapters 13,14 angeordnete Haltelasche 46 mit einer Aufnahmeöffnung 47. Zur Befestigung und Halterung des Adapters 13,14 wird die T-förmige Nut 45 auf das T-förmige Führungselement 40 eingeschoben, bis das Rastelement 42 der Anschlußleiste 20 in die Aufnahmeöffnung 47 der Haltelasche 46 eingreift. Beide Adapter 13,14 können nachträglich spiegelbildlich zueinander gerichtet an den Längsseiten 32,33 der Anschlußleiste 20 befestigt und durch Anheben der Haltelasche 46 entrastet und entfernt werden.

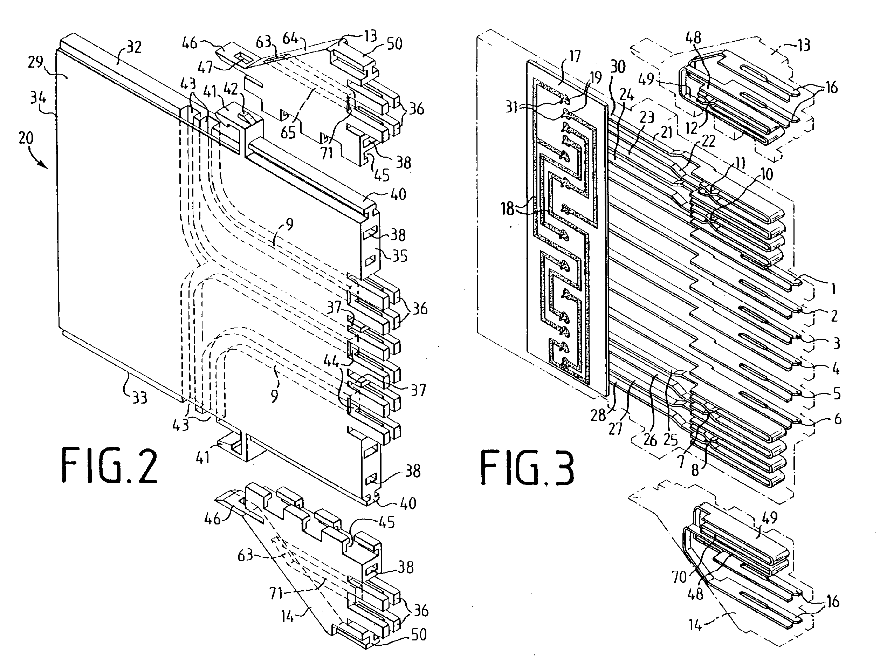

Im Adapter 13,14 sind, wie insbesondere Fig. 3 zeigt, zwei Anschlußkontakte 16 angeordnet, zwischen denen eine Trennstelle 12 oder eine Schaltstelle 70 angeordnet ist. Die Trennstelle 12 und die Schaltstelle 70 werden über zwei Trenn- bzw. Schaltkontakte 48,49 gebildet, die jeweils mit den Anschlußkontakten 16 einstückig verbunden sind.

An den Oberseiten der Adapter 13,14 sind darüber hinaus T-förmige Führungselemente 50 für weitere nicht dargestellte Zusatzelemente vorgesehen. An der Vorderseite der Adapter 13,14 sind ebenfalls Halterippen 36 im Bereich der Anschlußkontakte 16 und Aufnahmeöffnungen 38 als Zugang für die Trenn- bzw. Schaltstelle 12,70 vorgesehen.

Nach dem Aufrasten der Adapter 13,14 auf die Anschlußleiste 20 sind auch die im Adapter 13,14 angeordneten Anschlußkontakte 16 und Trenn- bwz. Schaltstellen 12,70 in einer Ebene mit den in der Anschlußleiste 20 angeordneten Anschlußkontakten 1 bis 6 und Trennstellen 7,8;10,11 angeordnet.

Zur Führung der Kabeladern besitzen die Adapter 13,14 je einen geradlinig verlaufenden Führungskanal 65 mit einer zwischen den Anschlußkontakten endenden Austrittsöffnung 71 und einer an der hinteren Seite 64 angeordneten Eintrittsöffnung 63.

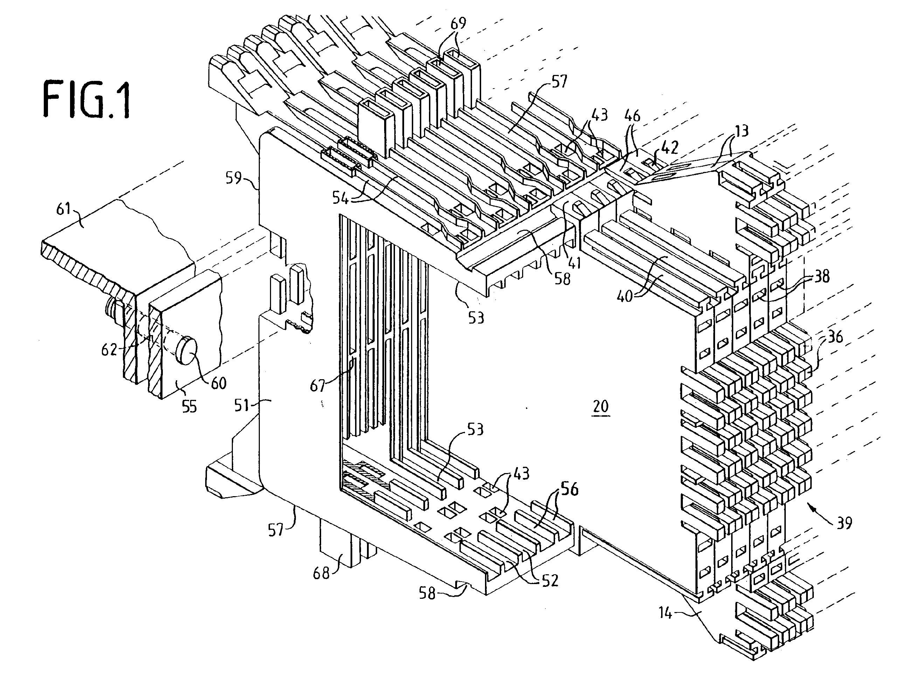

Die aus mehreren Anschlußleisten 20 und einer Aufnahmewanne 51 bestehende Anschlußvorrichtung wird vorzugsweise in Verteilergestellen eingesetzt. In Fig. 1 sind eine zum Verteilergestell gehörenden Befestigungsschiene 61 und die Anschlußvorrichtung für die waagerechte Vermittlungsseite eines Verteilergestelles dargestellt. Mehrere Anschlußleisten 20 sind hierbei dicht an dicht in die Aufnahmewanne 51 eingesetzt. Die Aufnahmewanne 51 besteht aus einem U-förmigen Kunststoffkörper, dessen offene Seite zur Vorderseite 39 des Verteilergestelles gerichtet ist und an dessen oberen und unteren Innenseiten 53 jeweils für eine Anschlußleiste 20 eine zur hinteren Bodenseite 67 der Aufnahmewanne 51 verlaufende, durch Rippen 56 gebildete Aufnahmenut 52 angeordnet ist. Die Aufnahmenuten 52 dienen zur Führung und Halterung der Anschlußleisten 20 und weisen Eintrittsöffnungen 43 auf, die mit den Eintrittsöffnungen 43 der Anschlußleiste 20 fluchten.

Nach dem Einstecken der Anschlußleiste 20 in die Aufnahmenut 52 der Aufnahmewanne 51 bilden die hintere Schmalseite 34 der Anschlußleiste 20 und die innere Bodenseite 67 der Aufnahmewanne 51 mit zwei Seitenflächen einen Leitungskanal 66 für die c-Ader der Vermittlungsleitung VL1 oder andere Sonderleitungen SL1, mit an den Außenseiten 57 der Aufnahmewanne 51 vorgesehenen Eintritts- und Austrittsöffnungen 68,69. Die c-Ader wird von unten in die Eintrittsöffnung 68 eingeschoben und im Leitungskanal 66 bis zur Austrittsöffnung 69 an der oberen Außenseite 57 der Aufnahmewanne 51 geführt. Die Rangier-, Vermittlungs- und Teilnehmerleitung RL1,VL1,VL2,TL1 werden an den oberen und unteren Außenseiten 57 der Aufnahmewanne 51 zwischen Führungsrippen 54 geführt.

An der oberen Außenseite 57 der Aufnahmewanne 51 wird die c-Ader bis zum Adapter 13 und dort durch den Führungskanal 65 an den Anschlußkontakt 16 herangeführt, an dem die c-Ader mittels eines nicht dargestellten Werkzeuges angeschlossen wird.

An den freien Enden der oberen und unteren Außenseiten 57 der U-förmigen Aufnahmewanne 51 sind längsverlaufende Rastnuten 58 vorgesehen, in die die Rasthaken 41 der Anschlußleisten 20 nach dem Einstecken der Anschlußleisten 20 in die Aufnahmewanne 51 einrasten. An der rückwärtigen Montageseite 59 der Aufnahmewanne 51 ist eine T-Nut vorgesehen, die zur Aufnahme einer Montageschiene 55 dient, die in bestimmten Abständen mit Schraubbolzen 60 versehen ist, die fest mit der Montageschiene 55 über eine Schweißverbindung bzw. Nietverbindung verbunden sind. Die Montageschiene 55 nimmt mehrere Aufnahmewannen 51 mit Anschlußleisten 20 auf und wird somit als Ganzes an eine Befestigungsschiene 61 eines nicht dargestellten Verteilergestells montiert. Die Befestigungsschiene 61 weist entsprechende Lochungen 62 auf, durch die die Schraubbolzen 60 der Montageschiene 55 eingesteckt sind. Die Aufnahmewanne 51 kann in verschiedenen Längen hergestellt werden, mit der entsprechenden Anzahl von eingesetzten Anschlußleisten 20.

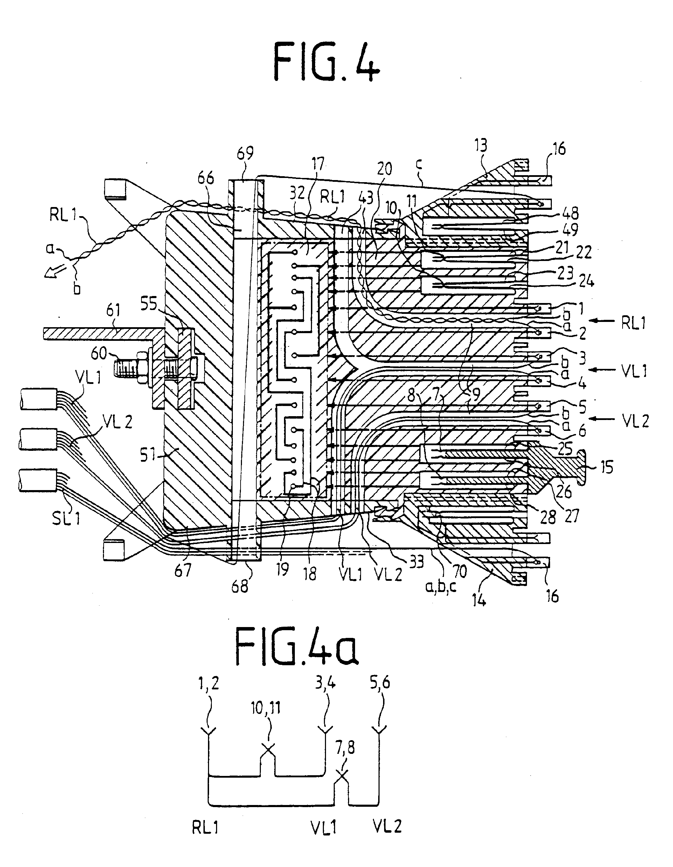

In den Figuren 4,5 und 6 wird anhand des ersten Ausführungsbeispiels der Anschlußleiste 20 der Umschaltvorgang dargestellt, wobei die beiden oberen Kontaktpaare 1,2 zum Anschluß einer aus a- und b-Ader bestehenden Rangierleitung RL1 und die Kontaktpaare 3,4 und 5,6 zum Anschluß von je einer Vermittlungsleitung VL1,VL2 dienen. Bei jedem Anschlußkontaktpaar 1,2;3,4;5,6 dient der obere Anschlußkontakt 1,3,5 zum Anschluß der b-Adern und der untere Anschlußkontakt 2,4,6 zum Anschluß der a-Ader. Die oberen Trennstellen 10,11 dienen zur Trennung der an den Anschlußkontakten 1,2 angeschlossenen Rangierleitung RL1 von der am Kontaktpaar 3,4 angeschlossenen ersten Vermittlungsleitung VL1. Die in der Anschlußleiste 20 angeordnete untere Trennstelle 7,8 dient zur Trennung der Rangierleitung RL1 und der am Kontaktpaaar 5,6 angeschlossenen Vermittlungsleitung VL2. Die entsprechenden Verbindungen zwischen den Anschlußkontakten 1 bis 6 und den Trennkontakten 21 bis 28 erfolgen über die auf der Leiterplattte 17 angeordneten Leiterbahnen 18.

Wie schematisch in Fig. 4a in einem Schaltbild dargestellt, bestehen folgende Verbindungen:

Für die b-Ader ist der Anschlußkontakt 1 zum Anschluß der Rangierleitung RL1 mit dem Trennkontakt 21 der Trennstelle 11 und mit dem Trennkontakt 25 der Trennstelle 7 verbunden. Der Trennkontakt 22 der Trennstelle 11 ist mit dem Anschlußkontakt 3 zum Anschluß der ersten Vermittlungsleitung VL1 und der Trennkontakt 26 der Trennstelle 7 mit dem Anschlußkontakt 5 zum Anschluß der zweiten Vermittlungsleitung VL2 verbunden.

Für die a-Ader ist der Anschlußkontakt 2 zum Anschluß der Rangierleitung RL1 mit dem Trennkontakt 23 der Trennstelle 10 und mit dem Trennkontakt 27 der Trennstelle 8 verbunden. Der Trennkontakt 24 der Trennstelle 10 ist mit dem Anschlußkontakt 4 zum Anschluß der ersten Vermittlungsleitung VL1 und der Trennkontakt 28 der Trennstelle 8 mit dem Anschlußkontakt 6 zum Anschluß der zweiten Vermittlungsleitung VL2 verbunden.

Durch diese Verbindungen ist das Kontaktpaar 1,2 zum Anschluß der Rangierleitung RL1 über eine Trennstelle 10,11 mit dem Kontaktpaar 3,4 zum Anschluß der ersten Vermittlungsleitung VL1 (erster Leitungsweg) und über eine weitere Trennstelle 7,8 mit dem Kontaktpaar 5,6 zum Anschluß der zweiten Vermittlungsleitung VL2 (zweiter Leitungsweg) verbunden.

Somit kann eine Umschaltung von einem ersten Leitungsweg (Rangierleitung/erste Vermittlungsleitung) auf einen zweiten Leitungsweg (Rangierleitung/zweite Vermittlungsleitung) hergestellt werden, deren Funktionsablauf in den Figuren 4,5 und 6 näher dargestellt ist.

In Figur 4 ist die Anschlußleiste 20 dargestellt, bei der an den Anschlußkontakten 1,2 die Rangierleitung RL1 angeschlossen ist. Die Rangierleitung RL1 wird hierbei von der rückwärtigen Montageseite 59 herangeführt, zwischen den Führungsrippen 54 der oberen Außenseite 57 geführt und in die Eintrittsöffnung 43 der oberen Außenseite 57 und der oberen Längsseite 33 der Anschlußleiste 20 eingeführt und durch den Führungskanal 9 bis an das Kontaktpaar 1,2 herangeführt und angeschlossen. Am Kontaktpaar 3,4 sind die a- und b-Adern der Vermittlungsleitung VL1 und an das Kontaktpaar 5,6 die Vermittlungsleitung VL2 angeschlossen. Beide Vermittlungsleitungen VL1,VL2 werden von der unteren Außenseite 57 herangeführt und in die Eintrittsöffnung 43 der unteren Außenseite 57 und der unteren Längsseite 34 der Anschlußleiste 20 in die Führungskanäle 9 eingeführt. An beiden Längsseiten 32,33 der Anschlußleiste 20 sind Adapter 13, 14 aufgerastet. Am an die obere Längsseite 32 aufgerasteten Adapter 13 sind am Anschlußkontakt 16 die c-Adern der ersten Vermittlungsleitung VL1 angeschlossen. An die an der unteren Längsseite 33 aufgerasteten Adapter 14 werden Sonderleitungen SL1 für z.B. Ansagedienste oder Erdleitungen angeschlossen.

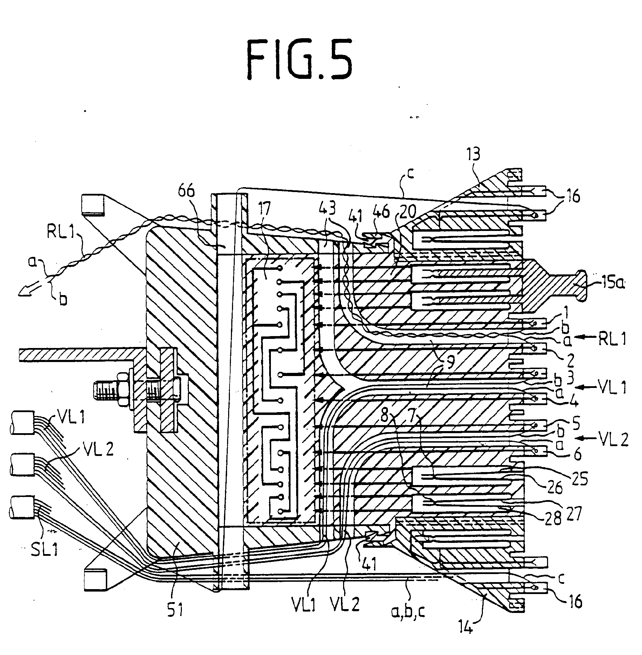

Zur Umschaltung des ersten Leitungsweges vom Kontaktpaar 1,2 zum Kontaktpaar 3,4 auf einen zweiten Leitungsweg vom Kontaktpaar 1,2 zum Kontaktpaar 5,6 muß vor Anschluß der Vermittlungsleitung VL2 ein Zweifach-Trennstecker 15 in die Trennstellen 7,8 eingesteckt werden, die Verbindung zwischen Rangierleitung RL1 und Vermittlungsleitung VL2 bleibt somit vorerst getrennt (Fig. 4). Als zweiter Schritt wird ein weiterer Zweifach-Trennstecker 15a in die Trennstellen 10,11 der Anschlußleiste 20 gesteckt, wodurch die Verbindung zwischen Rangierleitung RL1 und Vermittlungsleitung VL1 aufgetrennt ist (Fig. 5). Die am Adapter 13 angeschlossene c-Ader braucht nicht getrennt zu werden, da nur eine c-Ader angeschlossen ist. Hierdurch ist die Vermittlungsleitung VL1 von der Rangierleitung RL1 getrennt. Der Zweifach-Trennstecker 15 wird danach aus den Trennstellen 7,8 herausgezogen, wodurch die Vermittlungsleitung VL1 mit der Rangierleitung RL1 verbunden ist, wie es in Fig. 5 dargestellt ist.

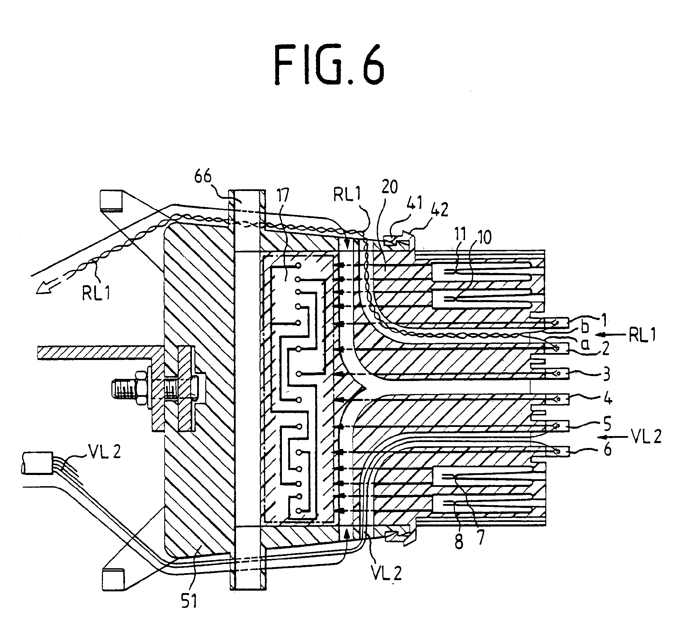

Wie die Fig. 6 zeigt, wird danach die nun nicht mehr benötigte Vermittlungsleitung VL1 von den Anschlußkontakten 3 und 4 abgeklemmt und aus dem Führungskanal 9 herausgezogen. Der Adapter 13 wird entfernt, da die Vermittlungsleitung VL2 nur noch aus der a- und b-Ader besteht. Der Adapter 14 kann bei Nichtbedarf entfernt werden. Auch der Trennstecker 15 kann nach dem Abtrennen der Vermittlungsleitung VL1 gezogen werden. Die nun freien Anschlußkontakte 3 und 4 können für parallele Anschaltungen oder spätere weitere Umschaltungen genutzt werden.

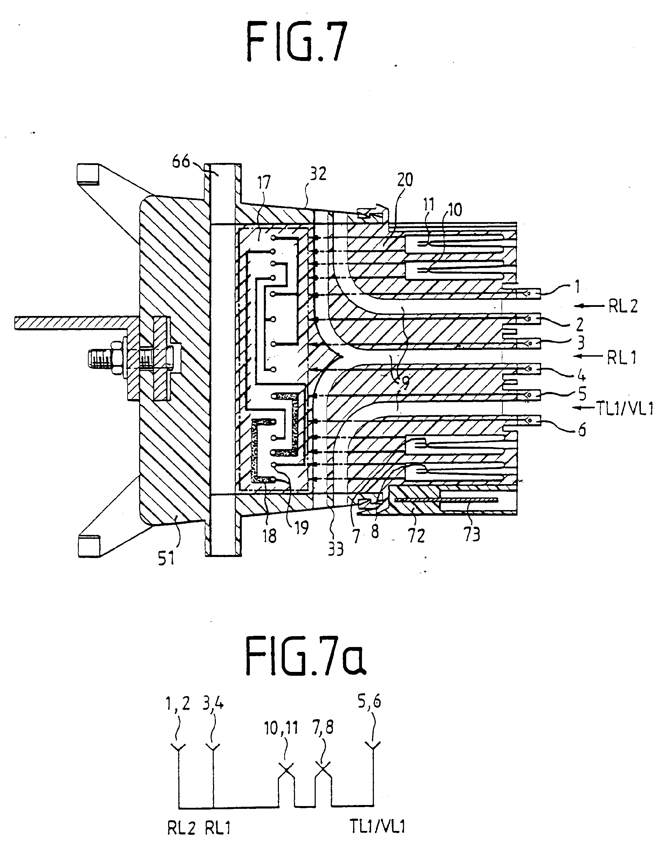

In der Figur 7 ist ein zweites Ausführungsbeispiel dargestellt, bei der die Anschlußleiste 20 auf der senkrechten oder waagerechten Seite des Verteilergestells angeordnet ist. Die elektrischen Verbindungen über die Leiterbahnen 18 zwischen den Anschlußkontakten 1 bis 6 und den Trennkontakten 21 bis 28 sind bei dieser Anschlußleiste 20 schematisch in einem Schaltbild dargestellt (Fig. 7a).

Für die b-Adern ist der Anschlußkontakt 1 für eine zweite Rangierleitung RL2 mit dem Anschlußkontakt 3 für eine erste Rangierleitung RL1 und dem Trennkontakt 21 der Trennstelle 11 verbunden. Der Trennkontakt 22 der Trennstelle 11 ist mit dem Trennkontakt 25 der Trennstelle 7 verbunden, dessen Trennkontakt 26 mit dem Anschlußkontakt 5 für eine Teilnehmerleitung TL1 oder Vermittlungsleitung VL1 verbunden ist.

Für die a-Adern ist der Anschlußkontakt 2 für die zweite Rangierleitung RL2 mit dem Anschlußkontakt 4 für die erste Rangierleitung RL1 und dem Trennkontakt 23 der Trennstelle 10 verbunden. Der Trennkontakt 24 der Trennstelle 10 ist mit dem Trennkontakt 27 der Trennstelle 8 verbunden, deren Trennkontakt 28 mit dem Anschlußkontakt 6 für die Teilnehmerleitung TL1 oder Vermittlungsleitung VL1 verbunden ist.

Durch diese Verbindungen sind dem Kontaktpaar 5,6 zum Anschluß der Teilnehmerleitungen TL1 oder Vermittlungsleitung VL1 zwei Kontaktpaare 1,2;3,4 für zwei Rangierleitungen RL1, RL2 über zwei Trennstellen 7,8;10,11 zugeordnet. In dem Leitungsweg können somit gleichzeitig Test- und Schutzstecker eingesteckt werden, da zwei Trennstellen 7,8;10,11 vorhanden sind. Für den nicht dargestellten Schutzstecker wird an der unteren Längsseite 32 der Anschlußleiste 20 ein Erd-Adapter 72 aufgerastet, der eine Erd-Sammelschiene 73 aufweist. Der Schutzstecker wird in die Trennstelle 7,8 und in den Erd-Adapter 73 eingesteckt, wodurch eine Erdverbindung von den Trennstellen 7,8 zur Erd-Sammelschiene 73 im Überspannungsfall hergestellt ist.

In vorteilhafter Weise ist der Anschluß für die a-Ader unten und für die b-Ader oben angeordnet, entsprechend der a-Ader-Trennstelle 7,10 und der b-Ader-Trennstelle 8,11.

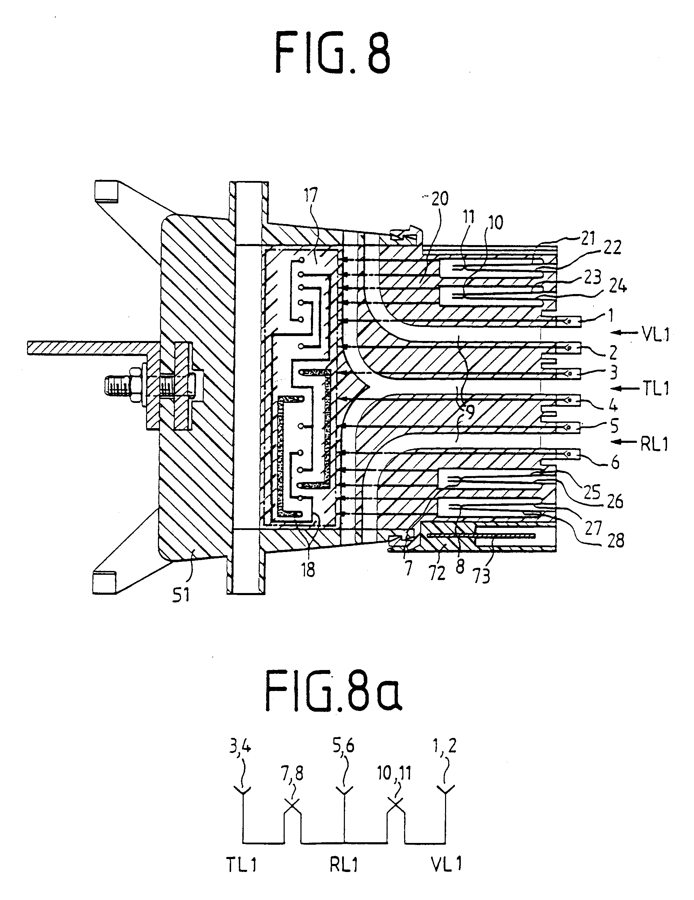

In Fig. 8 ist ein drittes Ausführungsbeispiel dargestellt, bei dem die Anschlußleiste 20 zum Anschluß für Teilnehmerleitungen TL1, Vermittlungsleitungen VL1 und Rangierleitungen RL1 dient. Die Verbindungen zwischen den Anschlußkontakten 1 bis 6 und den Trennkontakten 21 bis 28 erfolgen auch hier über die Leiterbahnen 18 der Leiterplatte 17 und sind in Fig. 8a schematisch in einem Schaltbild dargestellt.

Für die b-Ader ist der Anschlußkontakt 1 für die Vermittlungsleitung VL1 mit dem Trennkontakt 21 der Trennstelle 11 verbunden, dessen Trennkontakt 22 mit dem Anschlußkontakt 5 für die Rangierleitung RL1 verbunden ist.

Der Anschlußkontakt 5 ist mit dem Trennkontakt 25 der Trennstelle 7 verbunden, deren Trennkontakt 26 mit dem Anschlußkontakt 3 für die Teilnehmerleitung TL1 verbunden ist.

Für die a-Ader ist der Anschlußkontakt 2 für die Vermittlungsleitung VL1 mit dem Trennkontakt 23 der Trennstelle 10 verbunden, deren Trennkontakt 24 mit dem Anschlußkontakt 6 für die Rangierleitung RL1 verbunden ist. Der Anschlußkontakt 6 ist mit dem Trennkontakt 27 der Trennstelle 8 verbunden, deren Trennkontakt 28 mit dem Anschlußkontakt 4 für die Teilnehmerleitung 1 verbunden ist.

Durch diese Verbindungen ist dem Kontaktpaar 3,4 zum Anschluß der Teilnehmerleitung TL1 über die erste Trennstelle 7,8 ein Kontaktpaar 5,6 zum Anschluß der Rangierleitung RL1 und dem Kontaktpaar 5,6 über eine zweite Trennstelle 10,11 ein Kontaktpaar 1,2 zum Anschluß der Vermittlungsleitung VL1 zugeordnet.

Weitere Verknüpfungen bzw. Verbindungen zwischen den Kontaktpaaren und den Trennstellen sind durch entsprechende Leiterplatten möglich. In einer nicht dargestellten Ausführung erfolgen die Verbindungen zwischen mindestens zwei nebeneinander angeordneten Anschlußleisten 20 entweder über eine Verbindung von Leiterplatte zu Leiterplatte 17 oder über einen Verbindungsstecker, der die Trennstellen 7,8 oder 10,11 einer ersten Anschlußleiste 20 mit den Trennstellen 7,8 oder 10,11 mindestens einer zweiten Anschlußleiste 20 oder die Trennstellen 7,8 oder 10,11 bzw. 10,11,12 mit zwei bzw. drei Adaptern 14 über Verbindungsschnüre verbindet. Durch die Verknüpfungen wird z.B. die Anschlußkapazität vervielfacht.

BEZUGSZEICHENLISTE

| | | | |
|---|---|---|---|
| 1-6 | Anschlußkontakte | 45 | T-förmige Nut |
| 7,8 | Trennstelle | 46 | Haltelasche |
| 9 | Leitungsführungskanal | 47 | Aufnahmeöffnung |
| 10,11 | Trennstelle | 48,49 | Trenn-Schaltkontakte |
| 12 | Trennstelle Adapter | 50 | T-förmiges Führungselement |
| 13,14 | Adapter | 51 | Aufnahmewanne |
| 15,15a | Trennstecker | 52 | Aufnahmenut |
| 16 | Anschlußkontakt/ | 53 | Innenseiten |
| | Adapter | 54 | Führungsrippen |
| 17 | Leiterplatte | 55 | Montagegehäuse |
| 18 | Leiterbahnen | 56 | Rippen |
| 19 | Bohrungen | 57 | Außenseite |
| 20 | Anschlußleiste | 58 | Rastnuten |
| 21-28 | Trennkontakte | 59 | Montageseite |
| 29 | Gehäuse | 60 | Schraubbolzen |
| 30 | Verlängerungen | 61 | Befestigungsschiene |
| 31 | Haken | 62 | Lochungen |
| 32,33 | Längsseite | 63 | Eintrittsöffnung |
| 34,35 | Schmalseiten | 64 | hintere Seite |
| 36 | Halterippen | 65 | Führungskanal |
| 37 | Isolierrippe | 66 | Leitungskanal |
| 38 | Aufnahmeöffnung | 67 | Bodenseite |
| 39 | Vorderseite | 68,69 | Eintritts-Austritts-Öffnung |
| 40 | T-förmiges Führungs- | 70 | Schaltstelle |
| | element | 71 | Austrittsöffnung |
| 41 | Rasthaken | 72 | Erd-Adapter |
| 42 | Rastelement | 73 | Erd-Sammelschiene |
| 43 | Eintrittsöffnung | | |
| 44 | Austrittsöffnung | RL1,2 | Rangierleitung |
| | | VL1,2 | Vermittlungsleitung |
| | | TL1 | Teilnehmerleitung |
| | | SL1 | Sonderleitung |

**Patentansprüche**

1. Anschlußvorrichtung zum Schalten oder Trennen von Leitungswegen in Fernsprechvermittlungsanlagen, bestehend aus einer Aufnahmewannanne (51) und aus mehreren von dieser aufgenommenen Anschlußleisten (20), die aus einem Gehäuse (29) mit einem Kontaktpaar zum Anschluß von Rangierleitungen und mit einem Kontaktpaar zum An schluß von Vermittlungs- oder Teilnehmerleitungen gebildet sind, wobei die Kontaktpaare über zwei Trennstellen verbunden sind,

**dadurch gekennzeichnet,**

daß innerhalb einer Ebene drei Kontaktpaare (1,2;3,4;5,6) und zwei Paare von Trennstellen (7,8;10,11) in einer Anschlußleiste (20) angeordnet sind, wobei die Kontaktpaare (1,2;3,4;5,6) mit den Trennstellen (7,8;10,11) entsprechend der gewünschten Schalt- und Umschaltfunktion über Leiterbahnen (18) verbunden sind, die auf einer in der Anschlußleiste (20) gelagerten Leiterplatte (17) aufgebracht sind.

2.  Anschlußvorrichtung nach Anspruch 1,
    dadurch gekennzeichnet, daß zwischen den Anschlußkontakten (1-6) der Kontaktpaare der Anschlußleiste (20) Leitungsführungskanäle (9) mit an deren Längs- und Schmalseiten (32,33,35) vorgesehenen Eintritts- und Austrittsöffnungen (43,44) angeordnet sind.

3.  Anschlußvorrichtung nach Anspruch 1,
    dadurch gekennzeichnet, daß ein mittlerer Leitungsführungskanal (9) zwei Eintrittsöffnungen (43) an den beiden Längsseiten (32,33) und eine Austrittsöffnung (44) an der vorderen Schmalseite (35) der Anschlußleiste (20) aufweist.

4.  Anschlußvorrichtung nach Anspruch 1,
    dadurch gekennzeichnet, daß an den Längsseiten (32,33) der Anschlußleiste (20) mindestens ein Adapter (13,14) mit zwei Anschlußkontakten (16) und einer Trennstelle (12) oder Schaltstelle (70) über Rast- und Führungselemente (40,42) aufsetzbar ist.

5.  Anschlußvorrichtung nach den Ansprüchen 1 und 4,
    dadurch gekennzeichnet, daß die Trennstelle (12) des Adapters (13) und die Trennstellen (10,11) der Anschlußleiste (20) eine in einer Ebene liegende Dreifach-Trennstelle (10,11,12) bilden.

6.  Anschlußvorrichtung nach Anspruch 1,
    dadurch gekennzeichnet, daß die Leiterbahnen (18) von mindestens zwei Anschlußleisten (20) miteinander über ein Verbindungselement elektrisch verbunden sind.

7.  Abschlußvorrichtung nach Anspruch 1,
    dadurch gekennzeichnet, daß das Kontaktpaar (1,2) zum Anschluß der Rangierleitungen (RL1) über die erste Trennstelle (7,8) mit dem Kontaktpaar (5,6) zum Anschluß einer zweiten Vermittlungsleitung (VL2) und daß das Kontaktpaar (1,2) über die zweite Trennstelle (10,11) mit dem Kontaktpaar (3,4) zum Anschluß einer ersten Vermittlungsleitung (VL1) verbunden ist.

8.  Anschlußvorrichtung nach Anspruch 1,
    dadurch gekennzeichnet, daß das Kontaktpaar (5,6) zum Anschluß der Teilnehmerleitung (TL1) oder der Vermittlungsleitung (VL1) über die erste Trennstelle (7,8) und über die zweite Trennstelle (10,11) mit dem Kontaktpaar (1,2) und dem Kontaktpaar (3,4) zum Anschluß von zwei Rangierleitungen (RL1,RL2) verbunden ist.

9.  Anschlußvorrichtung nach Anspruch 1,
    dadurch gekennzeichnet, daß das Kontaktpaar (3,4) zum Anschluß einer Teilnehmerleitung (TL1) über die erste Trennstelle (7,8) und die zweite Trennstelle (10,11) zu dem Kontaktpaar (1,2) zum Anschluß der Vermittlungsleitung (VL1) und zwischen den beiden Trennstellen (7,8;10,11) das Kontaktpaar (5,6) zum Anschluß der Rangierleitung (RL1) geschaltet ist.

10. Anschlußvorrichtung nach Anspruch 1,
    dadurch gekennzeichnet, daß ein Leitungskanal (66) für die von der einen zur anderen Außenseite (57) der Aufnahmewanne (51) geführten Leitungen aus der hinteren Schmalseite (34) der Anschlußleiste (20) und aus einer inneren Bodenseite (67) mit zwei Seitenflächen einer U-förmigen Aufnahmewanne (51) gebildet ist, mit je einer Eintritts- und Austrittsöffnung (68,69) an den Außenseiten (57) der Aufnahmewanne (51).

11. Anschlußvorrichtung nach den Ansprüchen 1 und 4,

dadurch gekennzeichnet, daß die Trennstellen (12) oder die Schaltstellen (70) von mindestens zwei Adaptern (13,14) zweier Anschlußleisten (20) mindestens eine Zweifach-Trenn- oder -Schaltstelle bilden.

## Claims

1. A connection device for switching or disconnecting line paths in telephone exchanges, comprising a receiving tub (51) of several connector blocks (20) received therein, said connector blocks being formed of a housing (29) with a contact pair for the connection of jumper lines and with a contact pair for the connection of exchange or subscriber lines, the contact pairs being con-nected by two disconnecting positions, characterised by that within one plane three contact pairs (1, 2; 3, 4; 5, 6) and two pairs of disconnecting positions (7, 8; 10, 11) are disposed in a connector block (20), the contact pairs (1, 2; 3, 4; 5, 6) being connected to the disconnecting positions (7, 8; 10, 11) in a way corresponding to the desired switching and switching-over functions by circuit tracks (18) being provided on a printed-circuit board (17) held in the connector block (20).

2. A connection device according to claim 1, characterised by that between the connection contacts (1-6) of the contact pairs of the connector block (20) are disposed line guide channels (9) with entrance and exit openings (43, 44) provided at the longitudinal and narrow sides (32, 33, 35) thereof.

3. A connection device according to claim 1, characterised by that a central line guide channel (9) has two entrance openings (43) at the two longitudinal sides (32, 33) and an exit opening (44) at the front narrow side (35) of the connector block (20).

4. A connection device according to claim 1, characterised by that at the longitudinal sides (32, 33) of the connector block (20) can be placed at least one adaptor (13, 14) with two connection contacts (16) and a disconnecting position (12) or switching position (70) by latch and guide elements (40, 42).

5. A connection device according to claims 1 and 4, characterised by that the disconnecting position (12) of the adaptor (13) and the disconnecting positions (10, 11) of the connector block (20) form a triple disconnecting position (10, 11, 12) arranged in one plane.

6. A connection device according to claim 1, characterised by that the circuit tracks (18) of at least two connector blocks (20) are electrically connected to each other by a connection element.

7. A connection device according to claim 1, characterised by that the contact pair (1, 2) for the connection of the jumper lines (RL1) is connected by a first disconnecting position (7, 8) to the contact pair (5, 6) for the connection of a second exchange line (VL2) and that the contact pair (1, 2) is connected by a second disconnecting position (10, 11) to the contact pair (3, 4) for the connection of a first exchange line (VL1).

8. A connection device according to claim 1, characterised by that the contact pair (5, 6) for the connection of the subscriber line (RL1) or of the exchange line (VL1) is connected by the first disconnecting position (7, 8) and by the second disconnecting position (10, 11) to the contact pair (1, 2) and to the contact pair (3, 4) for the connection of two jumper lines (RL1, RL2).

9. A connection device according to claim 1, characterised by that the contact pair (3, 4) for the connection of a subscriber line (TL1) is connected by the first disconnecting position (7, 8) and by the second disconnecting position (10, 11) to the contact pair (1, 2) for the connection of the exchange line (VL1), and that between the two disconnecting positions (7, 8; 10, 11) is connected the contact pair (5, 6) for the connection of the jumper line (RL1).

10. A connection device according to claim 1, characterised by that a line channel (66) for the lines guided from the one to the other outer side (57) of the receiving tub (51) is formed of the rear narrow side (34) of the connector block (20) and of an inner bottom side (67) with two side faces of a U-shaped receiving tub (51) comprising one entrance and exit opening (68, 69) each at the outer sides (57) of the receiving tub (51).

11. A connection device according to claims 1 and 4, characterised by that the disconnecting positions (12) or the switching positions (70) of at least two adaptors (13, 14) of two connector blocks (20) form at least one double disconnecting or switching position.

## Revendications

1. Dispositif de raccordement pour la commutation ou la disconnexion de voies de ligne dans des centraux téléphoniques, comprenant une cuve de logement (51) et plusieurs blocs de connexion étant formés d'un boîtier (29) avec une paire de contact pour le raccordement de lignes d'interconnexion et avec une paire de contact pour le raccordement de lignes du central et d'abonné, lesdites paires de contact étant liées par deux positions de disconnexion,
   caractérisé en ce qu'au-dedans d'un plan sont disposées trois paires de contact (1, 2; 3, 4; 5, 6) et deux paires de positions de disconnexion (7, 8; 10, 11) dans un bloc de connexion (20), les paires de contact (1, 2; 3, 4; 5, 6) étant liées aux positions de disconnexion (7, 8; 10, 11) selon la fonction désirée de commutation par l'intermédiaire de pistes conductives (18) qui sont mises en place sur une carte imprimée (17) tenue dans le bloc de connexion (20).

2. Dispositif de raccordement selon la revendication 1,
   caractérisé en ce qu'entre les contacts de connexion (1-6) des paires de contact du bloc de connexion (20) sont prévus des canaux de guidage (9) pour les lignes ayant des ouvertures d'entrée et de sortie (43, 44) aux côtés longitudinaux et étroits (32, 33, 35) de ceux-ci.

3. Dispositif de raccordement selon la revendication 1,
   caractérisé en ce qu'un canal de guidage central (9) a deux ouvertures d'entrée (43) aux deux côtés longitudinaux (32, 33) et une ouverture de sortie (44) au côté étroit avant (35) du bloc de connexion (20).

4. Dispositif de raccordement selon la revendication 1,
   caractérisé en ce qu'aux côtés longitudinaux (32, 33) du bloc de connexion (20) peut être mis en place au moins un adapateur (13, 14) avec deux contacts de connexion (16) et une position de disconnexion (12) ou une position de commutation (70) par l'intermédiaire d'éléments d'encliquetage ou de guidage (40,42).

5. Dispositif de raccordement selon les revendications 1 à 4,
   caractérisé en ce que la position de disconnexion (12) de l'adapateur (13) et les positions de disconnexion (10, 11) du bloc de connexion (20) forment une position de disconnexion (10, 11, 12) triple.

6. Dispositif de raccordement selon la revendication 1,
   caractérisé en ce que les pistes conductives (18) d'au moins deux blocs de connexion (20) sont électriquement liées les unes aux autres par l'intermédiaire d'un élément de connexion.

7. Dispositif de raccordement selon la revendication 1,
   caractérisé en ce que la paire de contact (1, 2) pour le raccordement des lignes d'interconnexion (RL1) est liée par l'intermédiaire d'une première position de disconnexion (7, 8) à la paire de contact (5, 6) pour le raccordement d'une deuxième ligne du central (VL2) et que la paire de contact (1, 2) est liée par l'intermédiaire d'une deuxième position de disconnexion (10, 11) à la paire de contact (3, 4) pour le raccordement d'une première ligne du central (VL1).

8. Dispositif de raccordement selon la revendication 1,
   caractérisé en ce que la paire de contact (5, 6) pour le raccordement de la ligne d'abonné (TL1) ou de la ligne du central (VL1) est liée par l'intermédiaire de la première position de disconnexion (7, 8) et par l'intermédiaire de la deuxième position de disconnexion (10, 11) à la paire de contact (3, 4) pour le raccordement de deux lignes d'interconnexion (RL1, RL2).

9. Dispositif de raccordement selon la revendication 1,
   caractérisé en ce que la paire de contact (3, 4) pour le raccordement d'une ligne d'abonné (TL1) est connectée par l'intermédiaire de la première position de disconnexion (7, 8) et la deuxième position de disconnexion (10, 11) à la paire de contact (1, 2) pour le raccordement de la ligne du central (VL1), et qu'entre les deux positions de disconnexion (7, 8; 10, 11) est connectée la paire de contact (5, 6) pour le raccordement de la ligne d'interconnexion (RL1).

10. Dispositif de raccordement selon la revendication 1,
caractérisé en ce qu'un canal de ligne (66) pour les lignes guidées de l'un jusqu'à l'autre côté extérieur (57) de la cuve de logement (51) est formé du côté étroit arrière (34) du bloc de connexion (20) et du côté de fond intérieur (67) avec deux faces latérales d'une cuve de logement (51) en U, avec deux ouvertures d'entrée et de sortie (68, 69) chacune aux côtés extérieurs (57) de la cuve de logement (51).

11. Dispositif de raccordement selon les revendications 1 et 4,
caractérisé en ce que les positions de disconnexion (12) ou les positions de commutation (70) d'au moins deux adapateurs (13, 14) de deux blocs de connexion (20) forment au moins une position de disconnexion ou de commutation double.

FIG.1

FIG.3

FIG.2

# FIG.4

# FIG.4a

# FIG.5

# FIG.6

# FIG.7

# FIG.7a

# FIG. 8

# FIG. 8a